# EUROPEAN PATENT SPECIFICATION

(11) **EP 3 211 613 B1**
(45) Date of publication and mention of the grant of the patent: **06.06.2018**
(21) Application number: 17153416.7
(22) Date of filing: 26.01.2017
(51) Int. Cl.: G08B 13/08

(54) **DOOR AND WINDOW CONTACT SYSTEM AND METHOD THAT INCLUDE A MEMS ACCELEROMETER AND A MEMS MAGNETOMETER**
TÜR- UND FENSTER-KONTAKTSYSTEM UND -VERFAHREN MIT MEMS-BESCHLEUNIGUNGSMESSER UND MEMS-MAGNETOMETER
SYSTÈME ET PROCÉDÉ DE CONTACT DE PORTE ET DE FENÊTRE QUI COMPRENNENT UN ACCÉLÉROMÈTRE MEMS ET UN MAGNÉTOMÈTRE MEMS

(30) Priority: 23.02.2016 US 201615050855
(43) Date of publication of application: 30.08.2017
(73) Proprietor: Honeywell International Inc., Morris Plains, NJ 07950 (US)
(72) Inventor: SMITH, Richard Alan, Morris Plains, NJ 07950 (US)
(74) Representative: Houghton, Mark Phillip

(56) References cited:
- WO-A1-2014/154738
- WO-A1-2015/017805
- DE-A1-102013 220 176
- US-A1- 2015 330 140

## Description

The present invention relates generally to door and window contact systems and methods. More particularly, the present invention relates to door and window contact systems and methods that include MEMS accelerometers and MEMS magnetometers.

### BACKGROUND

Known intrusion detection systems can include door and window contact systems and methods that are based on reed and magnet technology. While inexpensive to implement, reed and magnet technology presents at least three significant limitations.

First, in reed and magnet technology, there are limitations on the distance of the gap between the electrical contacts of the reed switch. "Wide-gap" reed switches have had their maximum functional gap stretched to reliable limits through various methods. However, mounting the electrical contacts of the reed switch on surfaces constructed of ferrous metal materials can result in a magnetic field flux interference that reduces the maximum operating gap. To maximize the effective gap, an expensive magnet is required, which is undesirable.

Second, reed and magnet technology is vulnerable to attempts to defeat (AtD) the system by an intruder. For example, the electrical contacts in the reed switch can be defeated by an intruder introducing a magnet in close proximity to the reed. Some systems and methods are known to reduce such security vulnerability, but all incur additional cost, which is undesirable.

Furthermore, in some situations, a user may wish to arm the system while a window(s) is in a partially opened position. However, such a position will likely exceed the maximum functional gap of the electrical contacts of the reed switch. Accordingly, a "bypass" mode can be invoked, but the "bypass" mode can further compromise perimeter intrusion detection, thereby making attempts to defeat by an intruder more likely to be successful.

Finally, when reed and magnet technology is employed, a magnet must be installed in the system. Such an installation further adds to overall cost.

In view of the above, there is a continuing, ongoing need for a system and method to address the gap, security, and robustness limitations of known door and window contact systems and methods without increasing the overall cost thereof.

United States Patent Application US2015/0330140 discloses a position sensing system including magnetometer operably connected to a door, and may include an accelerometer to detect acceleration of the door. The accelerometer is used to determine when the magnetometer should be used to measure a position indicator of the door.

### SUMMARY OF INVENTION

The present invention in its various aspects is as set out in the appended claims.

### BRIEF DESCRIPTION OF THE DRAWINGS

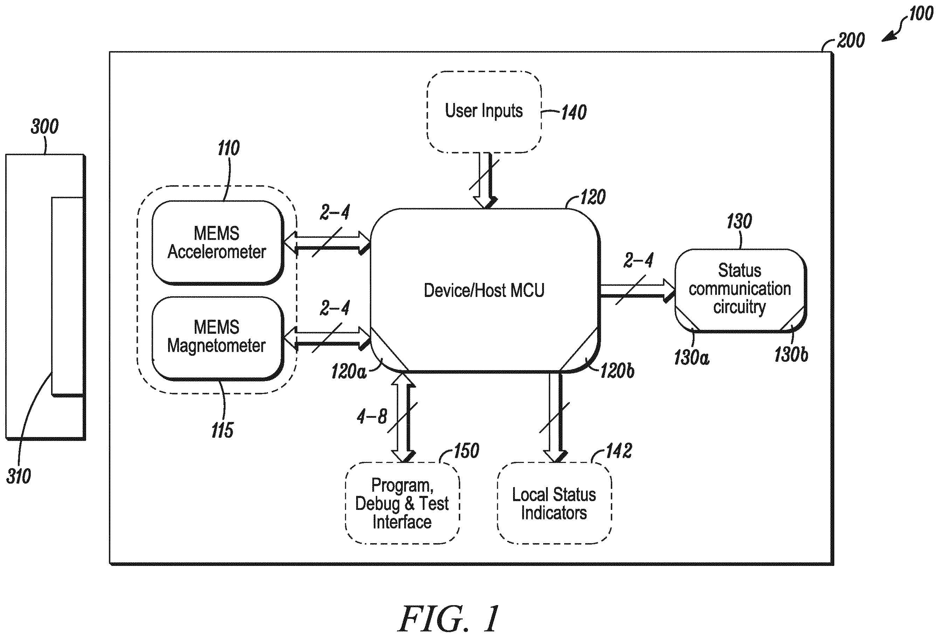

FIG. 1 is a block diagram of a system in accordance with disclosed embodiments.

### DETAILED DESCRIPTION

While this invention is susceptible of an embodiment in many different forms, there are shown in the drawings and will be described herein in detail specific embodiments thereof with the understanding that the present disclosure is to be considered as an exemplification of the principles of the invention. It is not intended to limit the invention to the specific illustrated embodiments.

Embodiments disclosed herein include systems and methods that address the gap, security, and robustness limitations of known door and window contact systems and methods without increasing the overall cost thereof. For example, the door and window contact systems and methods disclosed herein can include MEMS accelerometers and MEMS magnetometers. In some embodiments, a MEMS accelerometer and a MEMS magnetometer can be housed or included in the same device, such as a sensor integrated circuit (IC).

In some embodiments, each of the accelerometer and the magnetometer disclosed herein can include a single axis version or a 3-axis version. However, when a 3-axis version is included, the intelligence of systems and methods disclosed herein can be increased as compared to when the single axis version is included.

In some embodiments, the systems and methods disclosed herein can include a microcontroller unit or microprocessor that can execute intelligent signal analysis algorithms for detecting relative door or window movement, partial and complete closure events, and/or attempts to defeat. According to the present invention, the microcontroller unit execeutes a plurality of different signal analysis algorithms and can determine which one of the plurality of algorithms to execute based on received user input. Indeed, in some embodiments, the user input can specify whether a monitored window or door is to be monitored in an open, closed or partially open position, and the microcontroller unit can execute the appropriate signal analysis algorithm based on such input. Furthermore, in some embodiments, the microcontroller unit can execute an attempt to defeat analysis algorithm responsive to detecting a non-sensor magnet introduced into the ambient environment. In these embodiments, the microcontroller unit can determine whether any detected movement is a valid movement or an attempt to defeat event.

It is to be understood that, by combining accelerometer output with magnetometer output, the systems and methods disclosed herein can detect and confirm a plurality of events, including, but not limited to the following physical events related to doors, windows, or other moving objects: (1) relative movement, for example, defining a starting position (0,0) that is open or closed and armed or disarmed; (2) partial and complete closure, including previously detected open positions that resulted in a fault detection; (3) attempts to defeat, for example, when a magnetic field is introduced; (4) movement direction, for example, opening vs. closing, moving towards home, closed, or away from home or closed, previously detected open positions, and boundary limits identified during installation; and (5) sensor orientation, for example, at rest.

In accordance with disclosed embodiments, movement with a predetermined acceleration or vibration can be initially detected by analyzing the magnitudes on all axes or vectors of the accelerometer disclosed herein to determine whether movement has occurred. When such an analysis is indicative of movement, the magnitude of magnetic flux on all axes or vectors of the magnetometer disclosed herein can be analyzed to validate or confirm the detected movement. In some embodiments, the magnitude of acceleration or vibration on the axes or vectors of the accelerometer and/or the magnitude of magnetic flux on the axes or vectors of the magnetometer can be compared to predetermined reference values or expected values, and systems and methods disclosed herein can determine whether the results of such a comparison are indicative of the detected movement.

Additionally or alternatively, the magnitude of magnetic flux on the axes or vectors of the magnetometer can be periodically sampled and analyzed to determine whether a change in magnetic flux magnitude has occurred, to compare any new magnetic flux magnitude to predetermined reference values or expected values, and to determine whether the results of such a comparison are indicative of movement. When the comparison results are indicative of movement, the magnitude of acceleration or vibration detected on the axes or vectors of the accelerometer can be detected to validate or confirm the identified movement. In some embodiments, the magnitude of acceleration or vibration on the axes or vectors of the accelerometer can be compared to predetermined reference values or expected values, and systems and methods disclosed herein can determine whether the result of such a comparison are indicative of the identified movement.

In accordance with disclosed embodiments, when an attempt to defeat magnet is outside a predetermined range of the sensor circuit, the amount of influence of the attempt to defeat magnet on magnetic fields is dependent on the proximity of the sensor magnet to the sensor circuit. However, because movement of the sensor magnet can result in a magnetic field strength change detected by the sensor circuit, the attempt to defeat condition can be detected by systems and methods disclosed herein. When an attempt to defeat magnet is placed within the predetermined range of the sensor circuit, the magnitude of magnetic field on all axes of the sensor circuit can be low, which can cause the movement of the sensor magnet to be undetectable. However, when the sensor circuit moves with respect to both the sensor magnet and the attempt to defeat magnet, a change in the magnitude of the magnetic field can be detected. In any embodiment, when an attempt to defeat magnet is placed within close proximity of a sensor magnet, the attempt to defeat magnet can have minimal effect until the sensor magnet moves.

In accordance with disclosed embodiments, when a 3-axis version of a magnetometer is included in a sensor circuit and the magnitude of magnetic flux of at least two axes is below a predetermined reference value or expected value, systems and methods disclosed herein can determine that a non-sensor magnet is likely near the sensor circuit and that an attempt to defeat event may be occurring. Indeed, the magnetometer may be saturated by the non-sensor magnet. Similarly, when a single axis version of a magnetometer is included in a sensor circuit and the magnitude of magnetic flux of the single axis is above a predetermined reference value or expected value, systems and methods disclosed herein can determine that a non-sensor magnet is likely near the sensor circuit and that an attempt to defeat event may be occurring. In accordance with the above, the magnitude of acceleration or vibration detected on the axes or vectors of the accelerometer can be used to confirm any attempt to defeat event identified by the output of the magnetometer.

In some embodiments, each of the accelerometer and magnetometer can be sampled periodically and at predetermined intervals to optimize performance and power consumption. This is especially advantageous in battery powered embodiments.

It is to be understood that the reference values and expected values discussed above and herein can be predetermined while taking into account one or more of the following considerations: (1) geomagnetic field strength variation, (2) relative geolocation, (3) changes over time, and (4) field disturbances. For example, in some embodiments, the sensor circuit described above and herein and a sensor magnet can be installed as described herein, and during installation, spatial and flux line relationships of the magnet and sensor circuity, and magnetic field strength in open and closed positions, can be learned by systems and methods disclosed herein and responsive thereto, reference values and expected values can be identified. In some embodiments, such an installation mode can be entered when power is initially applied to the sensor circuit, and in some embodiments, the installation mode can span a predetermined period of time.

In accordance with the above and other embodiments disclosed herein, movement of a hinged window or door can be detected by sensing a change in the orientation of the window or door relative to the earth's poles and the predetermined reference values and expected values. However, movement vectors of a sliding window or door in a horizontal or vertical linear direction have a very low orientation change relative to the earth's poles. Accordingly, the change in magnetic field strength along the linear slide vector may be too low to detect within reasonable slide distances, except in cases where a mounting surface for a sensor circuit includes a door or window frame material that is made of a ferrous metal, which can have a significant effect on magnetic field strength and result in a distortion of magnetic flux lines that are discernible and change with movement. Systems and methods disclosed herein can overcome these obstacles to accurately and effectively detect the movement of a sliding door or window even when a mounting surface includes a non-ferrous metal.

An accelerometer or magnetometer in accordance with disclosed embodiments can be placed in one of a plurality of different locations. For example, in some embodiments, a sensing circuit chip that includes the accelerometer or magnetometer can be mounted in a window or door recess, for example, in a recessed channel of a window frame or in a recessed channel of a door frame on the side thereof supporting the hinge of a swinging door. In these embodiments, the sensing chip can sense the movement and magnetic field relative to a moving portion of the window or door. Additionally or alternatively, in some embodiments, a sensing circuit chip that includes the accelerometer or magnetometer can be mounted on a surface of a door or window, for example, on a moving part thereof, including on a window or a roll-up door. In these embodiments, the sensing chip can sense the movement and magnetic field relative to a non-moving portion, for example, a window or door frame.

FIG. 1 is a block diagram of a system 100 in accordance with disclosed embodiments. In some embodiments, the system 100 can be embodied in or on a chip and/or in a housing 200.

As seen in FIG. 1, the system 100 can include a MEMS accelerometer 110, a MEMS magnetometer 115, a microcontroller unit 120, communication circuitry 130, and a user interface that can include user input mechanisms 140 and user output mechanisms 142, for example, status indicators. In some embodiments, the system 100 can also include an interface 150 for programming, debugging, and testing the microcontroller unit 120.

As seen in FIG. 1, the microcontroller unit 120 can be in communication with each of the accelerometer 110, the magnetometer 115, the communication circuitry 130, the user input mechanisms 140, the user output mechanisms 142, and the interface 150. It is to be understood that some or all of this communication be wired and/or wireless as would be understood by one of ordinary skill in the art.

In some embodiments, the accelerometer 110 can transmit a signal to the microcontroller unit 120 indicative of the magnitude of measured acceleration or vibration on all axes or vectors of the accelerometers 110 and relative to a surface 300. Similarly, in some embodiments, the magnetometer 115 can transmit a signal to the microcontroller unit 120 indicative of the magnitude of measured magnetic flux on all axes or vectors of the magnetometer 115 and relative to a sensor magnet 310 that can be mounted on or embedded in the surface 300.

In accordance with the above, in some embodiments, the housing 200 and/or the sensor 110 can be mounted in or on a non-moving portion of a window or door, for example, the window or door frame, and the surface 300 can include a moving portion of a window or door, for example, the window or door itself. Additionally or alternatively, in some embodiments, the housing 200 and/or the sensor 100 can be mounted in or on a moving portion of a window or door, for example, the window or door itself, and the surface 300 can include a non-moving portion of a window or door, for example, the window or door frame.

The accelerometer 110 and the magnetometer 115 can transmit signals to the microcontroller unit 120 as described above, and the microcontroller unit 120 can use the received signals to make a security determination in accordance with disclosed embodiments. For example, in some embodiments, the microcontroller unit 120 can use the received signals to identify door or window movement, partial and complete closure events, or attempts to defeat.

According to the present invention, there is provided user input to the microcontroller unit 120 via the user input mechanisms 140. For example, in some embodiments, the user input can specify the allowed range of movement for the relevant window or door and/or specify whether the relevant window or door is to be monitored in a closed, open, or partially opened or closed position or state. The microcontroller unit 120 can use the received user input when making a security determination as described above. According to the present invention, the microcontroller unit 120 uses the received user input to determine an appropriate algorithm to execute when analyzing the received signals to make a security determination as described above.

Based on the results of the security determination, in some embodiments, the microcontroller unit 120 can provide an indication thereof to a user via the user output mechanisms 142. Additionally or alternatively, in some embodiments, the microcontroller unit 120 can transmit an indication of the results of the security determination to a remote or local security system via the communication circuitry 130.

It is be understood that the microcontroller unit 120 and/or the communication circuitry 130 can include one or more programmable processors 120a, 130a, and executable control software 120b, 130b as would be understood by one of ordinary skill in the art. The executable control software 120b, 130b can be stored on a transitory or non-transitory computer readable medium, including, but not limited to, local computer memory, RAM, optical storage media, magnetic storage media, flash memory, and the like. In some embodiments, the executable control software can include the signal analysis algorithms as described above and/or can make the security determinations as described above.

Although a few embodiments have been described in detail above, other modifications are possible. For example, the logic flows described above do not require the particular order described, or sequential order, to achieve desirable results. Other steps may be provided, or steps may be eliminated, from the described flows, and other components may be added to, or removed from, the described systems. Other embodiments may be within the scope of the invention.

The present invention in its various aspects is as set out in the appended claims.

## Claims

1. A system (100) comprising:
a MEMS accelerometer (110) for mounting in or on a first portion of a window unit or a door unit;
a MEMS magnetometer (115) for mounting in or on the first portion of the window unit or the door unit; and
a microcontroller unit (120) in communication with each of the MEMS accelerometer and the MEMS magnetometer,
wherein the MEMS accelerometer is operable to measure an acceleration or vibration value relative to a second portion (300) of the window unit or the door unit and transmit the acceleration or vibration value to the microcontroller unit,
wherein the MEMS magnetometer is operable to measure a magnetic field value relative to a sensor magnet (310) mounted on or embedded in the second portion of the window unit or the door unit and transmit the magnetic field value to the microcontroller unit,
wherein the microcontroller unit is configured to receive user input determining one of a plurality of preconfigured signal analysis algorithms to the MEMS accelerometer and the MEMS magnetometer for use in making a security determination, and
wherein the microcontroller unit is configured to use the acceleration or vibration value and the magnetic field value as inputs into the determined one of the plurality of preconfigured signal analysis algorithms to make the security determination.

2. The system (100) of claim 1 wherein the first portion of the window unit or the door unit includes a moving portion of the window unit or the door unit, and wherein the second portion (310) of the window unit or the door unit includes a non-moving portion of the window unit or the door unit.

3. The system (100) of claim 2 wherein the moving portion of the window unit or the door unit includes a window or a door, and wherein the non-moving portion (310) of the window unit or the door unit includes a window frame or a door frame.

4. The system (100) of claim 1 wherein the first portion of the window unit or the door unit includes a non-moving portion of the window unit or the door unit, and wherein the second portion (310) of the window unit or the door unit includes a moving portion of the window unit or the door unit.

5. The system (100) of claim 4 wherein the moving portion (310) of the window unit or the door unit includes a window or a door, and wherein the non-moving portion of the window unit or the door unit includes a window frame or a door frame.

6. The system (100) of claim 1 wherein the security determination is indicative of the window unit movement or door unit movement being within a predetermined range of movement, the window unit or the door unit being one of open, closed, or partially open or closed, or an attempt to defeat event occurring.

7. The system (100) of claim 6 wherein the one of the plurality of preconfigured signal analysis algorithms directs the microcontroller unit to compare at least one of the acceleration or vibration value and the magnetic field value to a predetermined reference value to determine whether the window unit movement or the door unit movement is within the predetermined range of movement, whether the window unit or the door unit is open, closed, or partially open or closed, or whether the attempt to defeat event is occurring.

8. The system (100) of claim 6 wherein the one of the plurality of preconfigured signal analysis algorithms directs the microcontroller unit to use the acceleration or vibration value to initially determine whether the window unit movement or the door unit movement is within the predetermined range of movement or whether the window unit or the door unit is open, closed, or partially opened or closed, and wherein the one of the plurality of preconfigured signal analysis algorithms directs the microcontroller unit to use the magnetic field value to confirm that the window unit movement or the door unit movement is within the predetermined range of movement or that the window unit or the door unit is open, closed, or partially opened or closed.

9. The system (100) of claim 6 wherein the one of the plurality of preconfigured signal analysis algorithms directs the microcontroller unit to use the magnetic field value to initially determine whether the window unit movement or the door unit movement is within the predetermined range of movement, whether the window unit or the door unit is open, closed, or partially opened or closed, or whether the attempt to defeat event is occurring, and wherein the one of the plurality of preconfigured signal analysis algorithms directs the microcontroller unit to use the acceleration or vibration value to confirm that the window unit movement or the door unit movement is within the predetermined range of movement, that the window unit or the door unit is open, closed, or partially opened or closed, or that the attempt to defeat event is occurring.

10. A method comprising:
mounting a MEMS accelerometer in or on a first portion of a window unit or a door unit;
mounting a MEMS magnetometer in or on the first portion of the window unit or the door unit;
the MEMS accelerometer measuring an acceleration or vibration value relative to a second portion of the window unit or the door unit and transmitting the acceleration or vibration value to a microcontroller unit;
the MEMS magnetometer measuring a magnetic field value relative to a sensor magnet mounted on or embedded in the second portion of the window unit or the door unit and transmitting the magnetic field value to the microcontroller unit;
the microcontroller unit receiving user input determining one of a plurality of preconfigured signal analysis algorithms to the MEMS accelerometer and the MEMS magnetometer for use in making a security determination, and
the microcontroller unit using the acceleration or vibration value and the magnetic field value as inputs into the determined one of the plurality of preconfigured signal analysis algorithms to make the security determination.

11. The system of claim 10 wherein the security determination is indicative of window unit movement or door unit movement being within a predetermined range of movement, the window unit or the door unit being one of open, closed, or partially open or closed, or an attempt to defeat event occurring.

12. The method of claim 11 further comprising the determined one of the plurality of preconfigured signal analysis algorithms directing the microcontroller unit to compare at least one of the acceleration or vibration value and the magnetic field value to a predetermined reference value to determine whether the window unit movement or the door unit movement is within the predetermined range of movement, whether the window unit or the door unit is open, closed, or partially open or closed, or whether the attempt to defeat event is occurring.

## Patentansprüche

1. System (100), umfassend:
einen MEMS-Beschleunigungsmesser (110) zur Montage in oder an einem ersten Teil einer Fenstereinheit oder einer Türeinheit;
ein MEMS-Magnetometer (115) zur Montage in oder an einem ersten Teil der Fenstereinheit oder der Türeinheit; und
eine Mikrocontrollereinheit (120) in Kommunikationsverbindung sowohl mit dem MEMS-Beschleunigungsmesser als auch mit dem MEMS-Magnetometer,
wobei der MEMS-Beschleunigungsmesser dazu betreibbar ist, einen Beschleunigungs- oder Vibrationswert in Bezug zu einem zweiten Teil (300) der Fenstereinheit oder der Türeinheit zu messen und den Beschleunigungs- oder Vibrationswert an die Mikrocontrollereinheit zu senden,
wobei das MEMS-Magnetometer dazu betreibbar ist, einen Magnetfeldwert in Bezug zu einem Sensormagneten (310), der am zweiten Teil der Fenstereinheit oder der Türeinheit montiert oder in diesen eingebettet ist, zu messen und oder den Magnetfeldwert an die Mikrocontrollereinheit zu senden,
wobei die Mikrocontrollereinheit dafür ausgelegt ist, eine Benutzereingabe zu empfangen, die einen von mehreren vorkonfigurierten Signalanalyse-Algorithmen zum MEMS-Beschleunigungsmesser und zum MEMS-Magnetometer bestimmt, um bei der Durchführung einer Sicherheitsbestimmung verwendet zu werden, und
wobei die Mikrocontrollereinheit dafür ausgelegt ist, den Beschleunigungs- oder Vibrationswert und den Magnetfeldwert als Eingänge in den bestimmten der mehreren vorkonfigurierten Signalanalyse-Algorithmen zu verwenden, um die Sicherheitsbestimmung durchzuführen.

2. System (100) nach Anspruch 1, wobei der erste Teil der Fenstereinheit oder der Türeinheit einen beweglichen Teil der Fenstereinheit oder der Türeinheit aufweist und wobei der zweite Teil (310) der Fenstereinheit oder der Türeinheit einen nicht beweglichen Teil der Fenstereinheit oder der Türeinheit aufweist.

3. System (100) nach Anspruch 2, wobei der bewegliche Teil der Fenstereinheit oder der Türeinheit ein Fenster oder eine Tür aufweist und wobei der nicht bewegliche Teil (310) der Fenstereinheit oder der Türeinheit einen Fensterrahmen oder einen Türrahmen aufweist.

4. System (100) nach Anspruch 1, wobei der erste Teil der Fenstereinheit oder der Türeinheit einen nicht beweglichen Teil der Fenstereinheit oder der Türeinheit aufweist und wobei der zweite Teil (310) der Fenstereinheit oder der Türeinheit einen beweglichen Teil der Fenstereinheit oder der Türeinheit aufweist.

5. System (100) nach Anspruch 4, wobei der bewegliche Teil (310) der Fenstereinheit oder der Türeinheit ein Fenster oder eine Tür aufweist und wobei der nicht bewegliche Teil der Fenstereinheit oder der Türeinheit einen Fensterrahmen oder einen Türrahmen aufweist.

6. System (100) nach Anspruch 1, wobei die Sicherheitsbestimmung indikativ dafür ist, dass eine Bewegung der Fenstereinheit oder eine Bewegung der Türeinheit innerhalb eines vorbestimmten Bewegungswertebereichs liegt, die Fenstereinheit oder die Türeinheit entweder offen, geschlossen oder teilweise offen bzw. geschlossen ist oder ein Manipulationsversuchereignis stattfindet.

7. System (100) nach Anspruch 6, wobei der eine der mehreren vorkonfigurierten Signalanalyse-Algorithmen die Mikrocontrollereinheit anweist, wenigstens entweder den Beschleunigungs- oder Vibrationswert oder den Magnetfeldwert mit einem vorbestimmten Referenzwert zu vergleichen, um zu bestimmen, ob die Bewegung der Fenstereinheit oder die Bewegung der Türeinheit innerhalb des vorbestimmten Bewegungswertebereichs liegt, ob die Fenstereinheit oder die Türeinheit offen, geschlossen oder teilweise offen bzw. geschlossen ist oder ob ein Manipulationsversuchereignis stattfindet.

8. System (100) nach Anspruch 6, wobei der eine der mehreren vorkonfigurierten Signalanalyse-Algorithmen die Mikrocontrollereinheit anweist, den Beschleunigungs- oder Vibrationswert zu verwenden, um anfänglich zu bestimmen, ob eine Bewegung der Fenstereinheit oder eine Bewegung der Türeinheit innerhalb des vorbestimmten Bewegungswertebereichs liegt oder ob die Fenstereinheit oder die Türeinheit offen, geschlossen oder teilweise offen bzw. geschlossen ist, und wobei der eine der mehreren vorkonfigurierten Signalanalyse-Algorithmen die Mikrocontrollereinheit anweist, den Magnetfeldwert zu verwenden, um zu bestätigen, dass die Bewegung der Fenstereinheit oder die Bewegung der Türeinheit innerhalb des vorbestimmten Bewegungswertebereichs liegt oder dass die Fenstereinheit oder die Türeinheit offen, geschlossen oder teilweise offen bzw. geschlossen ist.

9. System (100) nach Anspruch 6, wobei der eine der mehreren vorkonfigurierten Signalanalyse-Algorithmen die Mikrocontrollereinheit anweist, den Magnetfeldwert zu verwenden, um anfänglich zu bestimmen, ob die Bewegung der Fenstereinheit oder die Bewegung der Türeinheit innerhalb des vorbestimmten Bewegungswertebereichs liegt, ob die Fenstereinheit oder die Türeinheit offen, geschlossen oder teilweise offen bzw. geschlossen ist oder ob ein Manipulationsversuchereignis stattfindet, und wobei der eine der mehreren vorkonfigurierten Signalanalyse-Algorithmen die Mikrocontrollereinheit anweist, den Beschleunigungs- oder Vibrationswert zu verwenden, um zu bestätigen, dass die Bewegung der Fenstereinheit oder die Bewegung der Türeinheit innerhalb des vorbestimmten Bewegungswertebereichs liegt, dass die Fenstereinheit oder die Türeinheit offen, geschlossen oder teilweise offen bzw. geschlossen ist oder dass ein Manipulationsversuchereignis stattfindet.

10. Verfahren, umfassend:
Montieren eines MEMS-Beschleunigungsmessers in oder an einem ersten Teil einer Fenstereinheit oder einer Türeinheit;
Montieren eines MEMS-Magnetometers in oder an dem ersten Teil der Fenstereinheit oder der Türeinheit;
wobei der MEMS-Beschleunigungsmesser einen Beschleunigungs- oder Vibrationswert in Bezug zu einem zweiten Teil der Fenstereinheit oder der Türeinheit misst und den Beschleunigungs- oder Vibrationswert an eine Mikrocontrollereinheit sendet;
wobei das MEMS-Magnetometer einen Magnetfeldwert in Bezug zu einem Sensormagneten, der am zweiten Teil der Fenstereinheit oder der Türeinheit montiert oder in diesen eingebettet ist, misst und den Magnetfeldwert an die Mikrocontrollereinheit sendet;
wobei die Mikrocontrollereinheit eine Benutzereingabe empfängt, die einen von mehreren vorkonfigurierten Signalanalyse-Algorithmen zum MEMS-Beschleunigungsmesser und zum MEMS-Magnetometer bestimmt, um bei der Durchführung einer Sicherheitsbestimmung verwendet zu werden, und
wobei die Mikrocontrollereinheit den Beschleunigungs- oder Vibrationswert und den Magnetfeldwert als Eingänge in den bestimmten der mehreren vorkonfigurierten Signalanalyse-Algorithmen verwendet, um die Sicherheitsbestimmung durchzuführen.

11. System nach Anspruch 10, wobei die Sicherheitsbestimmung indikativ dafür ist, dass eine Bewegung der Fenstereinheit oder eine Bewegung der Türeinheit innerhalb eines vorbestimmten Bewegungswertebereichs liegt, die Fenstereinheit oder die Türeinheit entweder offen, geschlossen oder teilweise offen bzw. geschlossen ist oder ein Manipulationsversuchereignis stattfindet.

12. Verfahren nach Anspruch 11, ferner umfassend, dass der bestimmte der mehreren vorkonfigurierten Signalanalyse-Algorithmen die Mikrocontrollereinheit anweist, wenigstens entweder den Beschleunigungs- oder Vibrationswert oder den Magnetfeldwert mit einem vorbestimmten Referenzwert zu vergleichen, um zu bestimmen, ob die Bewegung der Fenstereinheit oder die Bewegung der Türeinheit innerhalb des vorbestimmten Bewegungswertebereichs liegt, ob die Fenstereinheit oder die Türeinheit offen, geschlossen oder teilweise offen bzw. geschlossen ist oder ob ein Manipulationsversuchereignis stattfindet.

## Revendications

1. Système (100) comportant :
un accéléromètre MEMS (110) destiné à être monté dans ou sur une première partie d'une unité de fenêtre ou d'une unité de porte ;
un magnétomètre MEMS (115) destiné à être monté dans ou sur la première partie de l'unité de fenêtre ou de l'unité de porte ; et
une unité (120) de microcontrôleur en communication avec chaque élément parmi l'accéléromètre MEMS et le magnétomètre MEMS,
l'accéléromètre MEMS étant exploitable pour mesurer une valeur d'accélération ou de vibration par rapport à une deuxième partie (300) de l'unité de fenêtre ou de l'unité de porte et envoyer la valeur d'accélération ou de vibration à l'unité de microcontrôleur,
le magnétomètre MEMS étant exploitable pour mesurer une valeur de champ magnétique par rapport à un aimant (310) de capteur monté sur ou encastré dans la deuxième partie de l'unité de fenêtre ou de l'unité de porte et envoyer la valeur de champ magnétique à l'unité de microcontrôleur,
l'unité de microcontrôleur étant configurée pour recevoir une entrée d'utilisateur déterminant un parmi une pluralité de algorithmes préconfigurés d'analyse de signaux pour l'accéléromètre MEMS et le magnétomètre MEMS à utiliser pour effectuer une détermination de sécurité, et
l'unité de microcontrôleur étant configuré pour utiliser la valeur d'accélération ou de vibration et la valeur de champ magnétique en tant qu'entrée dans l'algorithme déterminé parmi la pluralité d'algorithmes préconfigurés d'analyse de signaux pour effectuer la détermination de sécurité.

2. Système (100) selon la revendication 1, la première partie de l'unité de fenêtre ou de l'unité de porte comprenant une partie mobile de l'unité de fenêtre ou de l'unité de porte, et la deuxième partie (310) de l'unité de fenêtre ou de l'unité de porte comprenant une partie immobile de l'unité de fenêtre ou de l'unité de porte.

3. Système (100) selon la revendication 2, la partie mobile de l'unité de fenêtre ou de l'unité de porte comprenant une fenêtre ou une porte, et la partie immobile (310) de l'unité de fenêtre ou de l'unité de porte comprenant un cadre de fenêtre ou un cadre de porte.

4. Système (100) selon la revendication 1, la première partie de l'unité de fenêtre ou de l'unité de porte comprenant une partie immobile de l'unité de fenêtre ou de l'unité de porte, et la deuxième partie (310) de l'unité de fenêtre ou de l'unité de porte comprenant une partie mobile de l'unité de fenêtre ou de l'unité de porte.

5. Système (100) selon la revendication 4, la partie mobile (310) de l'unité de fenêtre ou de l'unité de porte comprenant une fenêtre ou une porte, et la partie immobile de l'unité de fenêtre ou de l'unité de porte comprenant un cadre de fenêtre ou un cadre de porte.

6. Système (100) selon la revendication 1, la détermination de sécurité étant indicative du fait que le mouvement de l'unité de fenêtre ou le mouvement de l'unité de porte se situe à l'intérieur d'une plage de mouvement prédéterminée, que l'unité de fenêtre ou l'unité de porte est soit ouverte, soit fermée, soit partiellement ouverte ou fermée, ou qu'un événement de tentative de dégradation a lieu.

7. Système (100) selon la revendication 6, l'algorithme parmi la pluralité d'algorithmes préconfigurés d'analyse de signaux enjoignant à l'unité de microcontrôleur de comparer au moins une valeur parmi la valeur d'accélération ou de vibration et la valeur de champ magnétique à une valeur de référence prédéterminée pour déterminer si le mouvement de l'unité de fenêtre ou le mouvement de l'unité de porte se situe à l'intérieur de la plage de mouvement prédéterminée, si l'unité de fenêtre ou l'unité de porte est ouverte, fermée, ou partiellement ouverte ou fermée, ou si l'événement de tentative de dégradation a lieu.

8. Système (100) selon la revendication 6, l'algorithme parmi la pluralité d'algorithmes préconfigurés d'analyse de signaux enjoignant à l'unité de microcontrôleur d'utiliser la valeur d'accélération ou de vibration pour déterminer initialement si le mouvement de l'unité de fenêtre ou le mouvement de l'unité de porte se situe à l'intérieur de la plage de mouvement prédéterminée ou si l'unité de fenêtre ou l'unité de porte est ouverte, fermée, ou partiellement ouverte ou fermée, et l'algorithme parmi la pluralité d'algorithmes préconfigurés d'analyse de signaux enjoignant à l'unité de microcontrôleur d'utiliser la valeur de champ magnétique pour confirmer que le mouvement de l'unité de fenêtre ou le mouvement de l'unité de porte se situe à l'intérieur de la plage de mouvement prédéterminée ou que l'unité de fenêtre ou l'unité de porte est ouverte, fermée, ou partiellement ouverte ou fermée.

9. Système (100) selon la revendication 6, l'algorithme parmi la pluralité d'algorithmes préconfigurés d'analyse de signaux enjoignant à l'unité de microcontrôleur d'utiliser la valeur de champ magnétique pour déterminer initialement si le mouvement de l'unité de fenêtre ou le mouvement de l'unité de porte se situe à l'intérieur de la plage de mouvement prédéterminée, si l'unité de fenêtre ou l'unité de porte est ouverte, fermée, ou partiellement ouverte ou fermée, ou si l'événement de tentative de dégradation a lieu, et l'algorithme parmi la pluralité d'algorithmes préconfigurés d'analyse de signaux enjoignant à l'unité de microcontrôleur d'utiliser la valeur d'accélération ou de vibration pour confirmer que le mouvement de l'unité de fenêtre ou le mouvement de l'unité de porte se situe à l'intérieur de la plage de mouvement prédéterminée, que l'unité de fenêtre ou l'unité de porte est ouverte, fermée, ou partiellement ouverte ou fermée, ou que l'événement de tentative de dégradation a lieu.

10. Procédé comportant les étapes consistant à :
monter un accéléromètre MEMS dans ou sur une première partie d'une unité de fenêtre ou d'une unité de porte ; monter un magnétomètre MEMS dans ou sur la première partie de l'unité de fenêtre ou de l'unité de porte ;
faire mesurer par l'accéléromètre MEMS une valeur d'accélération ou de vibration par rapport à une deuxième partie de l'unité de fenêtre ou de l'unité de porte et envoyer la valeur d'accélération ou de vibration à une unité de microcontrôleur ;
faire mesurer par le magnétomètre MEMS une valeur de champ magnétique par rapport à un aimant de capteur monté sur ou encastré dans la deuxième partie de l'unité de fenêtre ou de l'unité de porte et envoyer la valeur de champ magnétique à l'unité de microcontrôleur ;
faire recevoir par l'unité de microcontrôleur une entrée d'utilisateur déterminant un algorithme parmi une pluralité de algorithmes préconfigurés d'analyse de signaux pour l'accéléromètre MEMS et le magnétomètre MEMS à utiliser pour effectuer une détermination de sécurité, et
faire utiliser par l'unité de microcontrôleur la valeur d'accélération ou de vibration et la valeur de champ magnétique en tant qu'entrée dans l'algorithme déterminé parmi la pluralité d'algorithmes préconfigurés d'analyse de signaux pour effectuer la détermination de sécurité.

11. Système selon la revendication 10, la détermination de sécurité étant indicative du fait que le mouvement de l'unité de fenêtre ou mouvement de l'unité de porte se situe à l'intérieur d'une plage de mouvement prédéterminée, que l'unité de fenêtre ou l'unité de porte est soit ouverte, soit fermée, soit partiellement ouverte ou fermée, ou qu'un événement de tentative de dégradation a lieu.

12. Procédé selon la revendication 11, comportant en outre le fait que l'algorithme déterminé parmi la pluralité d'algorithmes préconfigurés d'analyse de signaux enjoint à l'unité de microcontrôleur de comparer au moins une valeur parmi la valeur d'accélération ou de vibration et la valeur de champ magnétique à une valeur de référence prédéterminée pour déterminer si le mouvement de l'unité de fenêtre ou le mouvement de l'unité de porte se situe à l'intérieur de la plage de mouvement prédéterminée, si l'unité de fenêtre ou l'unité de porte est ouverte, fermée, ou partiellement ouverte ou fermée, ou si l'événement de tentative de dégradation a lieu.
